# EUROPEAN PATENT APPLICATION

(11) **EP 3 562 273 A1**
(43) Date of publication of application: **30.10.2019**
(21) Application number: 18382284.0
(22) Date of filing: 26.04.2018
(51) Int. Cl.: H05B 37/02, H03K 3/00, H05B 33/08

(54) **ELECTRONIC ASSEMBLY AND LIGHTING DEVICE**

(71) Applicant: Valeo Iluminacion, 23600 Martos (ES)
(72) Inventor: MARIN, Maria, 23600 MARTOS (ES); SANTAELLA, Juan-Jose, 23600 MARTOS (ES); LOPEZ, Jose-Luis, 23600 MARTOS (ES)
(74) Representative: Valeo Vision

(57) **Abstract**

The invention is referred to an electronic assembly (1) for an automotive lighting device (10). This electronic assembly (1) comprises a first pattern generation unit (3), arranged in direct electric contact with the input (2), a first switching unit (4) arranged to receive the first signal pattern and produce a first switched signal and a first group of light source elements (5). The light source elements (7) are connected in parallel and each one comprises a serial connection of a light source (70) and a resistor (71). All of the light source elements (7) of the first group (5) are fed by the first switched signal. The invention also refers to a lighting device (10) comprising such an electronic assembly (1).

## Description

### TECHNICAL FIELD

This invention belongs to the field of lighting devices installed in automotive vehicles, and more specifically to the electronic assemblies used in these automotive lighting devices.

### STATE OF THE ART

Lighting devices installed in automotive vehicles usually comprise light sources mounted on a printed circuit board (PCB). These light sources are usually controlled to be selectively activated, so that different presentations may be achieved, depending on the function required by the user.

This control has been traditionally made by means of micro-controllers (uC), which are connected to each light source and performs a selective control so that light sources are selectively activated or deactivated by the micro-controller in order to achieve the required function.

The use of micro-controllers in lighting devices is therefore increasing, because these dynamic functionalities are being demanded by the main automotive manufacturers. However, these micro-controllers are expensive, and need to be programmed.

A different way of achieving these dynamic functions is therefore sought.

### DESCRIPTION OF THE INVENTION

In an inventive aspect, the invention provides an electronic assembly for an automotive lighting device, the electronic assembly comprising
an input intended to be fed by an activation electric signal;
a first pattern generation unit, arranged in direct electric contact with the input, and configured to produce a first signal pattern;
a first switching unit arranged to receive the first signal pattern and produce a first switched signal; and
a first group of light source elements which are connected in parallel, each light source element comprising a serial connection of a light source and a resistor, wherein all of the light source elements of the first group are fed by the first switched signal.

This electronic assembly performs a non-programmed control on the first group of light source elements, since the first pattern generation unit is a non-programmable element. In a particular embodiment, this signal pattern is a signal delay.

In a particular embodiment, the first pattern generation unit comprises at least one of a digital timer, a monostable, a reset generator, a R-C circuit, a voltage supervisor, a shift register, a programmable logic device, a field-programmable gate array or an application-specific integrated circuit.

All of these elements are non-programmable solutions for generating a signal pattern.

The first pattern generation unit only consists of hardware elements, with no software configuration. This is a cheap way of managing the dynamic functionalities of a lighting module without using expensive micro-controllers.

When an activation electric signal is received, such as a turning indicator activation signal, the first pattern generation unit receives this signal and creates a signal pattern, which depends on the lighting functionality associated to the electronic assembly.

For example, when the activation electric signal is a turning indicator signal, the first pattern generator unit receives a signal while the turning indicator is on. In this case, the first pattern generator unit delays the signal, since the first group of light source elements need to light later than a preceding module. By means of the switching unit, the light source elements are switched on or switched off as a whole, since they are connected in parallel. This configuration can be used, for example, in a fender-trunk part, where there are independent turning indicator modules, but which must provide a coordinated output.

In some particular embodiments, the first switching unit comprises a first transistor with in turn comprises
a base configured to receive the first signal pattern,
a collector connected to ground and
an emitter connected to the base of a second transistor,
the second transistor further comprising
an emitter connected to the base of the second transistor and providing a first output of the first switched signal and
a collector providing a second output of the first switched signal.

This is a simple way of obtaining a switched signal using common electronic elements which are non-programmable.

In some particular embodiments,
all the light source elements of the first group of light sources comprises a first terminal and a second terminal;
all the first terminals are fed by the first output of the first switched signal; and
all the second terminals are fed by the second output of the first switched signal.

This arrangement makes that all the light sources of the first group are fed in parallel. This is an advantageous alternative way of very important, since it prepares the electronic assembly for an electronic matrix assembly, and ensures lighting functionality even if one of the light source elements fails, due to the "n-1 rule".

In some particular embodiments, the electronic assembly further comprises
a second pattern generation unit, arranged in direct contact with the input, and configured to produce a second signal pattern;
a second switching unit arranged to receive the second signal pattern and produce a second delayed signal; and
a second group of light sources which are connected in parallel, all of the light sources of the second group being fed by the second switched signal.

This embodiment includes more than one row, for those lighting functionalities which require more than one interconnected group of light source elements.

In some particular embodiments, the second group of light sources are also fed by the first switched signal. This interconnection makes the first and second pattern generator unit be coordinated to provide a suitable coordination between the deactivation and activation of the different groups of light source elements.

In a particular embodiment, the second pattern generation unit comprises at least one of a digital timer, a monostable, a reset generator, a R-C circuit, a voltage supervisor, a shift register, a programmable logic device, a field-programmable gate array or an application-specific integrated circuit.

All of these elements are non-programmable solutions for generating a signal pattern.

In some particular embodiments, the second switching unit comprises a third transistor which in turn comprises
a base configured to receive the second signal pattern,
a collector connected to ground and
an emitter connected to the base of a fourth transistor,
the fourth transistor further comprising
an emitter connected to the base of the fourth transistor and providing a first output of the second switched signal and
a collector providing a second output of the second switched signal.

This is a simple way of obtaining a switched signal using common electronic elements which are non-programmable.

In some particular embodiments,
all the light source elements of the second group comprise a first terminal and a second terminal;
all the first terminals are fed by the second output of the first switched signal; and
all the second terminals are fed by the second output of the second switched signal.

This arrangement extends the advantages of the parallel connection to the second group of light source elements and configures a proper matrix arrangement, where there is an interconnection between the output terminals of one group of light sources and the input terminals of the next group of light sources.

In some particular embodiments,
all the light sources of the third group of light sources comprises a first terminal and a second terminal;
all the first terminals are fed by the second output of the second switched signal; and
all the second terminals are connected to ground.

This is an extended matrix arrangement. Obviously, there may be more groups of light source elements connected in the same way.

In some particular embodiments, the light sources are solid-state light sources, such as light emitting diodes (LEDs).

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the life span of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

In a second inventive aspect, the invention provides a lighting device comprising an electronic assembly according to the first inventive aspect.

This lighting device is particularly useful in automotive applications, for lighting functionalities where a coordinated response is required, but may be obtained without the use of an expensive programmed controller.

In some particular embodiments, the lighting device further comprises a first optical element arranged to receive light from the plurality of light sources and to shape the light into a light pattern projected outside the lighting device.

An optical element is an element that has some optical properties to receive a light beam and emit it in a certain direction and/or shape, as a person skilled in automotive lighting would construe without any additional burden.

In some particular embodiments, the optical element is at least one of a light guide, a lens, a reflector or a collimator.

These optical elements are useful to manage the light produced by the plurality of light sources and provide uniform output.

In some particular embodiments, the lighting device is a a turning indicator, a cornering light, a fixed bending light or a daytime running lamp.

These lighting functionalities are typical to use a group of light sources to provide the coordinated response.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows an electronic assembly 1 according to the invention.
Figure 2 shows a lighting device comprising an electronic assembly according to the invention.

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

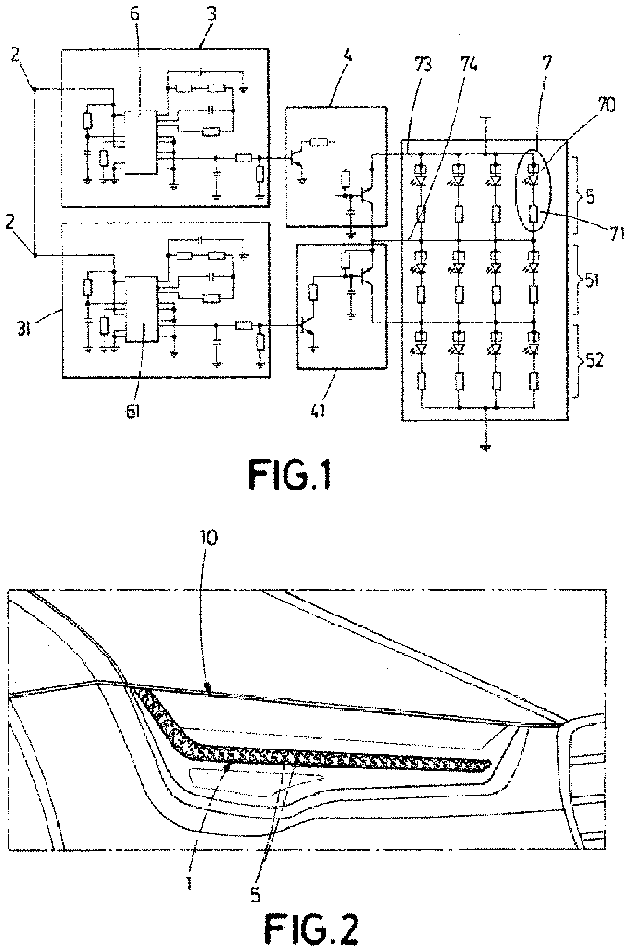

Figure 1 shows an electronic assembly 1 according to the invention. This electronic assembly is suitable for being used in an automotive lighting device.

The electronic assembly 1 comprises the following elements:
an input 2;
a first and a second pattern generation units 3, 31, arranged in direct electric contact with the input 2;
a first and a second switching unit 4, 41; and
a first, a second and a third group of light source elements 5, 51, 52.

The input 2 is intended to receive an activation signal when a functionality provided by the light sources is required. This activation signal may be, e. g., a turning indicator activation signal. The activation signal may be an "on-off" signal, as in this case, although in other embodiments could be a more complex signal.

The first and second pattern generation units 3, 31 are arranged to cause two predetermined and different delays in the activation signal. As may be seen in this figure, each one comprises a digital timer 6, 61 and some passive elements, which are non-programmable and therefore, very easy to get and assemble. Other non-programmable elements, such as a monostable, a reset generator, a R-C circuit, a voltage supervisor, a shift register, a programmable logic device, a field-programmable gate array or an application-specific integrated circuit may be also used for this purpose.

Each output of the pattern generation units provides a delayed signal. The delayed signal from the first pattern generator unit 3 is sent to the first switching unit 4 and the delayed signal from the second pattern generator unit 31 is sent to the second switching unit 41.

The first and second switching units 4, 41, are arranged to received one delayed signal and produce a switched signal. Hence, the first switching unit 4 receives the first delayed signal from the first pattern generator unit 3 and produces a first switched signal. The second switching unit 41, in turn, receives the second delayed signal from the second pattern generator unit 31 and produces a second switched signal.

Each switching unit 4, 41 comprises a first transistor and a second transistor. The base of the first transistor receives the corresponding signal pattern, the collector of the first transistor is connected to ground and the emitter of the first transistor is connected to the base of the second transistor. The emitter of the second transistor is connected to the base of the second transistor and provides a first output of the corresponding switched signal. The collector provides a second output of the corresponding switching signal.

The electronic assembly also comprises three groups of light source elements 5, 51, 52. Each light source element 7 is the serial connection of a LED 70 and a resistor 71. Each group of light source elements 5, 51, 52 comprises a parallel connection of four light source elements 7. As a consequence, each group of light source elements comprises a first terminal 73, which is common for all the light source elements of the same group, and a second terminal 74, which is common for all the light source elements of the same group.

The groups of light source elements are arranged in a matrix configuration. The first terminal of the first group of light sources 5 is fed by the first of the first switched signal and the second terminal of the first group is fed by the second output of the first switched signal. The first terminal of the second group of light sources 51 is fed by the second output of the first switched signal, which is connected to the first output of the second switched signal, and the second terminal of the second group of light sources is fed by the second output of the second switched signal. Finally, the first terminal of the third group of light source elements 52 is fed by the second output of the second switched signal and the second terminal of the third group is connected to ground.

Figure 2 shows a lighting device 10 comprising an electronic assembly 1 according to the invention. This lighting device comprises a turning indicator.

This lighting device comprises a projecting lens which receives the light of the plurality of LEDs and shape it into a light pattern projected outside the lighting device.

## Claims

1. Electronic assembly (1) for an automotive lighting device (10), the electronic assembly (1) comprising
an input (2) intended to be fed by an activation electric signal;
a first pattern generation unit (3), arranged in direct electric contact with the input (2), and configured to produce a first signal pattern;
a first switching unit (4) arranged to receive the first signal pattern and produce a first switched signal; and
a first group of light source elements (5) which are connected in parallel, each light source element (7) comprising a serial connection of a light source (70) and a resistor (71), wherein all of the light source elements of the first group (5) are fed by the first switched signal.

2. Electronic assembly (1) according to claim 1, wherein the first pattern generator unit (3) comprises at least one of a digital timer (6), a monostable, a reset generator, a R-C circuit, a voltage supervisor, a shift register, a programmable logic device, a field-programmable gate array or an application-specific integrated circuit.

3. Electronic assembly (1) according to any of the preceding claims, wherein the first switching unit (4) comprises a first transistor with in turn comprises
a base configured to receive the first signal pattern,
a collector connected to ground and
an emitter connected to the base of a second transistor,
the second transistor further comprising
an emitter connected to the base of the second transistor and providing a first output of the first switched signal and
a collector providing a second output of the first switched signal.

4. Electronic assembly (1) according to claim 3, wherein
all the light source elements of the first group comprises a first terminal (73) and a second terminal (74);
all the first terminals are fed by the first output of the first switched signal; and
all the second terminals are fed by the second output of the first switched signal.

5. Electronic assembly (1) according to any of the claims 3 or 4, further comprising
a second pattern generation unit (31), arranged in direct contact with the input (2), and configured to produce a second signal pattern;
a second switching unit (41) arranged to receive the second signal pattern and produce a second delayed signal; and
a second group of light source elements (51) which are connected in parallel, each light source element comprising a serial connection of a light source and a resistor, wherein all of the light source elements of the second group are fed by the second switched signal.

6. Electronic assembly (1) according to claim 5, wherein the second group of light source elements (51) are also fed by the first switched signal.

7. Electronic assembly (1) according to any of claims 5 or 6, wherein the second pattern generator unit (31) comprises at least one of a digital timer (61), a monostable, a reset generator, a R-C circuit, a voltage supervisor, a shift register, a programmable logic device, a field-programmable gate array or an application-specific integrated circuit.

8. Electronic assembly (1) according to any of claims 5 to 7, wherein the second switching unit (41) comprises a third transistor which in turn comprises
a base configured to receive the second signal pattern,
a collector connected to ground and
an emitter connected to the base of a fourth transistor,
the fourth transistor further comprising
an emitter connected to the base of the fourth transistor and providing a first output of the second switched signal and
a collector providing a second output of the second switched signal.

9. Electronic assembly (1) according to claim 8, wherein
all the light source elements of the second group comprise a first terminal and a second terminal;
all the first terminals are fed by the second output of the first switched signal; and
all the second terminals are fed by the second output of the second switched signal.

10. Electronic assembly (1) according to claim 9, further comprising a third group of light source elements (52), each light source element comprising a serial connection of a light source and a resistor, wherein
all the light source elements of the third group comprises a first terminal and a second terminal;
all the first terminals are fed by the second output of the second switched signal; and
all the second terminals are connected to ground.

11. Electronic assembly (1) according to any of the preceding claims, wherein the light sources are solid-state light sources, such as light emitting diodes or LEDs.

12. Lighting device (10) comprising an electronic assembly (1) according to any of the preceding claims.

13. Lighting device (10) according to claim 12, further comprising a first optical element arranged to receive light from the plurality of light sources (5) and to shape the light into a light pattern projected outside the lighting device.

14. Lighting device (10) according to claim 13, wherein the optical element is at least one of a lens, a light guide, a reflector or a collimator.

15. Lighting device (10) according to any of claims 12 to 14, the lighting device (10) being a fog lamp, a turning indicator, a low beam headlamp, a high beam headlamp, a cornering light, a fixed bending light or a daytime running lamp.
